# EUROPEAN PATENT APPLICATION

(11) **EP 4 310 922 A1**
(43) Date of publication of application: **24.01.2024**
(21) Application number: 21940507.3
(22) Date of filing: 11.11.2021
(51) Int. Cl.: H01L 31/0216, H01L 31/068, H01L 31/18

(54) **GALLIUM OXIDE BACK-PASSIVATED SOLAR CELL AND PREPARATION METHOD THEREFOR**

(30) Priority: 21.05.2021 CN 202110558290; 21.05.2021 CN 202121099336 U
(71) Applicant: Hengdian Group DMEGC Magnetics Co., Ltd., Jinhua, Zhejiang 322118 (CN)
(72) Inventor: FANG, Chaoyan, Jinhua, Zhejiang 322118 (CN); HE, Yue, Jinhua, Zhejiang 322118 (CN); REN, Hailiang, Jinhua, Zhejiang 322118 (CN); REN, Yong, Jinhua, Zhejiang 322118 (CN); CHEN, Deshuang, Jinhua, Zhejiang 322118 (CN)
(74) Representative: De Bonis, Paolo
(86) International application number: PCT/CN2021/129967
(87) International publication number: WO 2022/242063

(57) **Abstract**

The present application provides a gallium oxide back-passivated solar cell and a preparation method therefor. The solar cell comprises a P-type silicon substrate. A front coating and a back coating are respectively provided on two opposite side surfaces of the P-type silicon substrate. The front coating comprises an emitter, a front silicon oxide layer, and a front silicon nitride layer which are sequentially stacked from the surface of the P-type silicon substrate to the outside. The back coating comprises a silicon oxide passivation layer, a gallium oxide passivation layer, and a back passivation layer which are sequentially stacked from the surface of the P-type silicon substrate to the outside.

## Description

### TECHNICAL FIELD

The present application belongs to the field of solar cells, and relates to back-passivated cells, for example, a gallium oxide back-passivated solar cell and a preparation method therefor.

### BACKGROUND

The cell technology of passivating emitter and back side, which originated in the 1980s, can improve conversion efficiency by stacking a passivation layer on the back side of a conventional cell. The coating process is an extremely important part in the solar cell production process. During the production process, the cell sheet needs to be coated with an anti-reflection film on the front side to reduce light reflection and enhance light absorption. A passivation film is coated on the back side. Generally, the passivation film can passivate the dangling bonds on the silicon surface to reduce the recombination rate on the surface and thus play the role of passivation. At the same time, its high refractive index can enhance the reflectivity of the back side and further improve the efficiency of the cell. It can be concluded that the passivation film directly affects the performance of solar cell.

At present, the back passivation of the cell commonly adopts the layer-stacking technology of stacking aluminum oxide and silicon nitride. The aluminum oxide thin film has good chemical passivation and field-effect passivation effects on both P-type and N-type silicon surfaces. The hydrogen content of the aluminum oxide thin film is about 2-4at%, and after the annealing process, the saturation effect of H diffused to the interface for the dangling bonds is beneficial to reduce the surface state density and improve the chemical passivation. Meanwhile, the fixed negative charge in the thin film provides the excellent field-effect passivation, which is generally considered to be related to the coordination structure of Al, O and H. Aluminum oxide has a dielectric constant of 7-9 and almost no absorption of visible light, and thus can be an ideal material for high-efficiency solar cells. However, its refractive index is low, only 1.65.

CN106711239A discloses a preparation method for a PERC solar cell, including a back silver electrode, an all-aluminum back surface field, a back silicon nitride film, an aluminum oxide film, a P-type silicon, an N-type emitter, a front silicon nitride film and a front silver electrode arranged in sequence from the bottom to the top; the back silicon nitride film has a slot through the back silicon nitride film and the aluminum oxide film, the P-type silicon is exposed in the slot, part of the all-aluminum back surface field, which is located in the slot, is connected to the P-type silicon, and a silicon oxide film is added between the N-type emitter and the front silicon nitride film.

CN109065639A discloses an N-type crystalline silicon solar cell and a preparation method, and a photovoltaic module, including a front electrode, a front passivation layer, an emitter, an N-type crystalline P-type silicon substrate, a back passivation layer and a back electrode arranged in sequence; the front passivation layer includes a gallium oxide layer in direct contact with the emitter. The gallium oxide layer has a thickness of 1-120 nm. The front passivation layer also includes a cover layer arranged on the gallium oxide layer, and the cover layer includes at least one of a silicon nitride layer, a silicon oxynitride layer, a silicon oxide layer, and a silicon carbide layer, and has a thickness of 10-120 nm.

CN112002771A discloses a P-type gallium-doped PERC cell with gallium-doped back surface field and a preparation method therefor, including a P-type gallium-doped silicon substrate, a gallium oxide layer arranged on the back side of the substrate, and a silicon nitride layer arranged on the gallium oxide layer; a local passivation field, i.e. a gallium-doped back surface field, is arranged in the gallium oxide layer, the silicon nitride layer and the substrate, a back electrode is arranged on the silicon nitride layer, and the back electrode forms an Ohmic contact with the silicon wafer through the gallium-doped back surface field. The cell further includes: an emitter layer arranged on the front side of the substrate and a selective emitter layer arranged in the metal region, a silicon oxide layer arranged on the emitter layer, a silicon nitride layer arranged on the silicon oxide layer, and a positive electrode arranged on the silicon nitride layer, and the positive electrode forms an Ohmic contact with the silicon wafer through the selective emitter.

The solar cells disclosed in the above patents have certain passivation performance. On this basis, it has been an urgent problem to be solved about how to further improve the chemical passivation effect of the cell surface and improve the comprehensive performance of the solar cell at the same time.

### SUMMARY

The present application is to provide a gallium oxide back-passivated solar cell and a preparation method therefor, which can enhance the passivation effect and improve the comprehensive performance of the solar cell.

To achieve the object, the present application adopts the technical solutions below.

In a first aspect, the present application provides a gallium oxide back-passivated solar cell, wherein the solar cell includes a P-type silicon substrate, the P-type silicon substrate is provided with a front coating and a back coating on the surfaces of opposite sides, respectively, the front coating includes an emitter, a front silicon oxide layer and a front silicon nitride layer stacked in sequence outward from the surface of the P-type silicon substrate, and the back coating includes a silicon oxide passivation layer, a gallium oxide passivation layer and a back passivation layer stacked in sequence outward from the surface of the P-type silicon substrate.

For the gallium oxide back-passivated solar cell provided by the present application, the field-effect passivation resulted from gallium oxide by fixing negative charges is used in conjunction with the chemical passivation of silicon oxide to further reduce carrier recombination; the silicon oxide passivation layer with controllable thickness, which is deposited between the gallium oxide passivation layer and the P-type silicon substrate, can effectively reduce the surface state density and further enhance the chemical passivation effect.

It should be noted that the P-type silicon substrate provided in the present application is prepared by doping a silicon crystal with a small amount of impurity boron or gallium. Exemplarily, in a case where a small amount of impurity gallium is doped, the silicon atom in the silicon crystal is replaced by the impurity atom, and a "hole" is generated when the three outer electrons of the gallium atom form covalent bonds with the surrounding silicon atoms. The hole may attract an electron to "fill", thus converting the gallium atom into an ion with negative charge. The P-type silicon substrate becomes electrically conductive due to having the high concentration of "holes".

As an optional technical solution of the present application, the cell includes a front electrode which penetrates through the front silicon nitride layer, the front silicon oxide layer and the emitter in sequence and inserts into the P-type silicon substrate, and the front electrode forms an Ohmic contact with the P-type silicon substrate.

It should be noted that the front electrode in the present application forms an Ohmic contact with the P-type silicon substrate through the emitter, i.e., a high-low junction structure is formed by high-concentration doping in the selective region of the P-type silicon substrate surface, which reduces the front recombination, and at the same time, substantially reduces the series resistance, enhances the transport performance of the electron hole, and improves the efficiency of the solar cell.

Optionally, the cell further includes a back electrode which penetrates through the back passivation layer, the gallium oxide passivation layer and the silicon oxide passivation layer in sequence and inserts into the P-type silicon substrate, and the back electrode forms an Ohmic contact with the P-type silicon substrate.

It should be noted that a local passivation field, i.e., a gallium-doped back surface field, is arranged in the gallium oxide passivation layer, the silicon nitride passivation layer and the P-type silicon substrate in the back coating of the solar cell provided by the present application, and the back electrode forms an Ohmic contact with the P-type silicon substrate through the gallium-doped back surface field.

As an optional technical solution of the present application, the back passivation layer includes any one or a combination of at least two of silicon nitride, silicon oxynitride or silicon carbide.

As an optional technical solution of the present application, the silicon oxide passivation layer has a thickness of 1-15 nm, such as 1 nm, 1.5 nm, 2 nm, 2.5 nm, 3 nm, 3.5 nm, 4 nm, 4.5 nm, 5 nm, 5.5 nm, 6 nm, 6.5 nm, 7 nm, 7.5 nm, 8 nm, 8.5 nm, 9 nm, 9.5 nm, 10 nm, 10.5 nm, 11 nm, 11.5 nm, 12 nm, 12.5 nm, 13 nm, 13.5 nm, 14 nm, 14.5 nm and 15 nm; however, the thickness is not limited to the listed values, and other unlisted values within the numerical range are also applicable.

Optionally, the gallium oxide passivation layer has a thickness of 10-100 nm, such as 10 nm, 15 nm, 20 nm, 25 nm, 30 nm, 35 nm, 40 nm, 45 nm, 50 nm, 55 nm, 60 nm, 65 nm, 70 nm, 75 nm, 80 nm, 85 nm, 90 nm, 95 nm and 100 nm; however, the thickness is not limited to the listed values, and other unlisted values within the numerical range are also applicable.

The thickness of the gallium oxide passivation layer is further optionally selected from 20-40 nm, such as 20 nm, 21 nm, 22 nm, 23 nm, 24 nm, 25 nm, 26 nm, 28 nm, 29 nm, 30 nm, 31 nm, 32 nm, 33 nm, 34 nm, 35 nm, 36 nm, 37 nm, 38 nm, 39 nm and 40 nm; however, the thickness is not limited to the listed values, and other unlisted values within the numerical range are also applicable.

Optionally, the back passivation layer has a thickness of 10-200 nm, such as 10 nm, 15 nm, 20 nm, 25 nm, 30 nm, 40 nm, 45 nm, 50 nm, 55 nm, 60 nm, 70 nm, 80 nm, 85 nm, 90 nm, 100 nm, 110 nm, 120 nm, 130 nm, 140 nm, 150 nm, 160 nm, 170 nm, 180 nm, 190 nm and 200 nm; however, the thickness is not limited to the listed values, and other unlisted values within the numerical range are also applicable.

The thickness of the back passivation layer is further optionally selected from 60-80 nm, such as 60 nm, 61 nm, 62 nm, 63 nm, 64 nm, 65 nm, 66 nm, 67 nm, 68 nm, 69 nm, 70 nm, 71 nm, 72 nm, 73 nm, 74 nm, 75 nm, 76 nm, 77 nm, 78 nm, 79 nm and 80 nm; however, the thickness is not limited to the listed values, and other unlisted values within the numerical range are also applicable.

Optionally, the front silicon oxide layer has a thickness of 1-5 nm, such as 1 nm, 1.5 nm, 2 nm, 2.5 nm, 3 nm, 3.5 nm, 4 nm, 4.5 nm and 5 nm; however, the thickness is not limited to the listed values, and other unlisted values within the numerical range are also applicable.

Optionally, the front silicon nitride layer has a thickness of 10-200 nm, such as 10 nm, 15 nm, 20 nm, 25 nm, 30 nm, 40 nm, 45 nm, 50 nm, 55 nm, 60 nm, 70 nm, 80 nm, 85 nm, 90 nm, 100 nm, 110 nm, 120 nm, 130 nm, 140 nm, 150 nm, 160 nm, 170 nm, 180 nm, 190 nm and 200 nm; however, the thickness is not limited to the listed values, and other unlisted values within the numerical range are also applicable.

The thickness of the front silicon nitride layer is further optionally selected from 60-80 nm, such as 60 nm, 61 nm, 62 nm, 63 nm, 64 nm, 65 nm, 66 nm, 67 nm, 68 nm, 69 nm, 70 nm, 71 nm, 72 nm, 73 nm, 74 nm, 75 nm, 76 nm, 77 nm, 78 nm, 79 nm and 80 nm; however, the thickness is not limited to the listed values, and other unlisted values within the numerical range are also applicable.

In a second aspect, the present application provides a preparation method for the solar cell according to the first aspect, and the preparation method includes:
performing laser doping to form an emitter on one surface of a P-type silicon substrate, then performing thermal oxidation to form a front silicon oxide layer, subsequently depositing a silicon oxide passivation layer, a gallium oxide passivation layer and a back passivation layer in sequence on the other surface of the P-type silicon substrate opposite to the front silicon oxide layer, and subsequently depositing a front silicon nitride layer on the surface of the formed front silicon oxide layer.

For the preparation method for a gallium oxide back-passivated solar cell provided by the present application, the field-effect passivation resulted from gallium oxide by fixing negative charges is used in conjunction with the chemical passivation of silicon oxide to further reduce carrier recombination; in addition to serving as the back passivation material, gallium oxide also contributes to the local heavy doping on the surface of the P-type silicon substrate by laser doping, which provides the effects of both chemical passivation and high-low junction field-effect passivation.

As an optional technical solution of the present application, the preparation method specifically includes:
(I) performing texturization on a silicon wafer surface to form a textured surface, then performing phosphorus diffusion on the surface, then performing laser doping to form an emitter on the surface of a P-type silicon substrate, etching and removing a phosphorus-silicon layer on the residual surface of the P-type silicon substrate, and subsequently performing thermal oxidation on the surface of the emitter to form a front silicon oxide layer;
(II) depositing a silicon oxide passivation layer, a gallium oxide passivation layer and a back passivation layer in sequence on the other surface of the P-type silicon substrate opposite to the front silicon oxide layer to obtain a back coating;
(III) depositing a front silicon nitride layer on the surface of the formed front silicon oxide layer to complete the preparation of a front coating; and
(IV) performing laser doping to form a gallium-doped back surface field from the surface of the back passivation layer to the inside of the P-type silicon substrate, and subsequently performing screen printing and sintering to form a front electrode and a back electrode.

As an optional technical solution of the present application, in step (I), a mixed solution of an alkali solution, water and an additive is used to form the textured surface on the silicon wafer surface.

Optionally, the alkali solution, the water and the additive have a volume ratio of (8-12): (240-360):(2-3), such as 8:240:2, 8:300:2, 8:360:2, 8:300:3, 8:360:3, 10:240:2, 10:300:2, 10:300:2, 10:360:3, 12:240:2, 12:300:2, 12:360:2, 12:240:3, 12:300:3, and 12:360:3; however, the volume ratio is not limited to the listed values, and other unlisted values within the numerical range are also applicable.

Optionally, the texturization has a temperature of 70-90°C, such as 70°C, 71°C, 72°C, 73°C, 74°C, 75°C, 76°C, 77°C, 78°C, 79°C, 80°C, 81°C, 82°C, 83°C, 84°C, 85°C, 86°C, 87°C, 88°C, 89°C and 90°C; however, the temperature is not limited to the listed values, and other unlisted values within the numerical range are also applicable.

Optionally, the alkaline solution is KOH and/or NaOH.

Optionally, the additive is ethanol and/or isopropanol.

As an optional technical solution of the present application, in step (I), the phosphorus-silicon layer is removed from the surface of the P-type silicon substrate with an acid solution by wet etching.

Optionally, the acid solution is an aqueous solution of HF.

Optionally, the water and HF in the acid solution have a volume ratio of (35-45):3, such as 35:3, 36:3, 37:3, 38:3, 39:3, 40:3, 41:3, 42:3, 43:3, 44:3 and 45:3; however, the volume ratio is not limited to the listed values, and other unlisted values within the numerical range are also applicable.

As an optional technical solution of the present application, in step (II), plasma-enhanced chemical vapor deposition is used to deposit the silicon oxide passivation layer on the surface of the P-type silicon substrate.

Optionally, the silicon oxide passivation layer has a deposition time of 30-150 s, such as 30 s, 32 s, 35 s, 40 s, 45 s, 50 s, 55 s, 60 s, 65 s, 70 s, 75 s, 80 s, 85 s, 90 s, 95 s, 100 s, 101 s, 102 s, 103 s, 104 s, 105 s, 108 s, 110 s, 112 s, 114 s, 115 s, 118 s, 120 s, 122 s, 123 s, 124 s, 125 s, 130 s, 135 s, 140 s, 145 s, 148 s and 150 s; however, the deposition time is not limited to the listed values, and other unlisted values within the numerical range are also applicable.

Optionally, SiH₄ and N₂O are used as reaction gases in the deposition of the silicon oxide passivation layer.

Optionally, the SiH₄ has a volume flow rate of 550-700 sccm, such as 550 sccm, 555 sccm, 560 sccm, 570 sccm, 580 sccm, 590 sccm, 600 sccm, 610 sccm, 620 sccm, 630 sccm, 640 sccm, 650 sccm, 660 sccm, 670 sccm, 680 sccm, 690 sccm, and 700 sccm; however, the volume flow rate is not limited to the listed values, and other unlisted values within the numerical range are also applicable.

Optionally, the N₂O has a volume flow rate of 3000-3250 sccm, such as 3000 sccm, 3050 sccm, 3100 sccm, 3110 sccm, 3120 sccm, 3150 sccm, 3180 sccm, 3200 sccm, 3210 sccm, 3230 sccm, 3240 sccm, 3245 sccm and 3250 sccm; however, the volume flow rate is not limited to the listed values, and other unlisted values within the numerical range are also applicable.

It should be noted that SiH₄ and N₂O are used as reaction gases in the deposition of the silicon oxide passivation layer; during the reaction, SiH₄ and N₂O generate plasma under the action of a high-frequency electric field, which contains a large number of silicon radicals, oxygen radicals and hydrogen radicals, and subsequently, the oxygen radicals and silicon radicals recombine to form silicon oxide. The generated silicon-based oxide thin film material contains a certain amount of hydrogen, and the hydrogen is able to fill the dangling bonds in the material structure, greatly reducing the defect level.

Optionally, plasma-enhanced chemical vapor deposition is used to deposit the back passivation layer.

Optionally, the preparation method for the gallium oxide passivation layer includes atomic layer deposition, plasma-enhanced chemical vapor deposition, atmospheric pressure chemical vapor deposition or low pressure chemical vapor deposition.

As an optional technical solution of the present application, in step (III), plasma-enhanced chemical vapor deposition is used to deposit the front silicon nitride layer on the surface of the front silicon oxide layer.

Compared with the prior art, the beneficial effects of the present application include:
for the gallium oxide back-passivated solar cell and the preparation method therefor provided by the present application, the field-effect passivation resulted from gallium oxide by fixing negative charges is used in conjunction with the chemical passivation of silicon oxide to further reduce carrier recombination; the silicon oxide passivation layer with controllable thickness, which is deposited between the gallium oxide passivation layer and the P-type silicon substrate, can effectively reduce the surface state density and enhance the chemical passivation effect; in addition to serving as the back passivation material, gallium oxide also contributes to the local heavy doping on the surface of the P-type silicon substrate by laser doping, which provides the effects of both chemical passivation and high-low junction field-effect passivation.

### BRIEF DESCRIPTION OF DRAWINGS

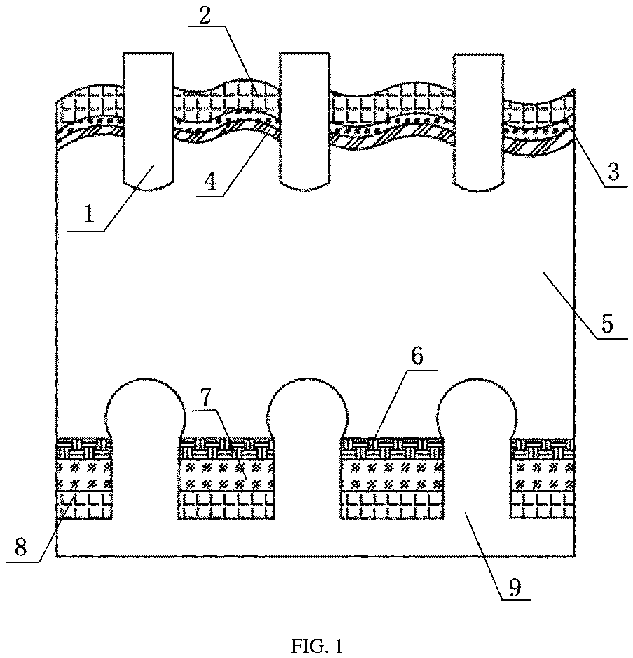

FIG. 1 is a schematic structural diagram of a gallium oxide back-passivated solar cell provided in an embodiment of the present application.

In the figure, 1-front electrode; 2-front silicon nitride layer; 3-front silicon oxide layer; 4-emitter; 5-P-type silicon substrate; 6-silicon oxide passivation layer; 7-gallium oxide passivation layer; 8-back passivation layer; and 9-back electrode.

### DETAILED DESCRIPTION

It should be understood that in the description of the present application, the terms "center", "lengthways", "crosswise", "over", "under", "front", "back", "left", "right", "vertical", "horizontal", "top", "bottom", "inner", "outer" and the like indicate an orientation or a positional relationship based on an orientation or a positional relationship shown in the drawing, which is only used for describing the present application conveniently and simplifying the description, rather than indicating or implying that the device or unit referred to necessarily has a particular orientation or needs to be arranged and operated in a particular orientation, and thereby should not be construed as a limitation to the present application. In the description of the present application, unless otherwise specified, "a plurality of" refers to two or more.

The technical solutions of the present application are further described below with reference to the drawing and the detailed description.

In an embodiment, the present application provides a gallium oxide back-passivated solar cell, which includes a P-type silicon substrate 5, and the P-type silicon substrate 5 is provided with a front coating and a back coating on the surfaces of opposite sides, respectively. As shown in FIG. 1, the front coating includes an emitter 4, a front silicon oxide layer 3 and a front silicon nitride layer 2 stacked in sequence outward from the surface of the P-type silicon substrate 5, wherein the front silicon oxide layer 3 has a thickness of 1-5 nm, and the front silicon nitride layer 2 has a thickness of 10-200 nm.

The back coating includes a silicon oxide passivation layer 6, a gallium oxide passivation layer 7 and a back passivation layer 8 stacked in sequence outward from the surface of the P-type silicon substrate 5; wherein the gallium oxide passivation layer 7 has a thickness of 10-100 nm, optionally 20-40 nm, and the silicon oxide passivation layer 6 has a thickness of 1-15 nm. The back passivation layer 8 includes any one or a combination of at least two of silicon nitride, silicon oxynitride or silicon carbide, which has a thickness of 10-200 nm, optionally 60-80 nm.

The solar cell includes a front electrode 1 which penetrates through the front silicon nitride layer 2, the front silicon oxide layer 3 and the emitter 4 in sequence and inserts into the P-type silicon substrate 5, and the front electrode 1 forms an Ohmic contact with the P-type silicon substrate 5. The solar cell also includes a back electrode 9 which penetrates through the back passivation layer 8, the gallium oxide passivation layer 7 and the silicon oxide passivation layer 6 in sequence and inserts into the P-type silicon substrate 5, and the back electrode 9 forms an Ohmic contact with the P-type silicon substrate 5.

In another embodiment, the present application provides a preparation method for the solar cell according to an embodiment, including:
performing laser doping to form an emitter 4 on one surface of a P-type silicon substrate 5, then performing thermal oxidation to form a front silicon oxide layer 3, subsequently depositing a silicon oxide passivation layer 6, a gallium oxide passivation layer 7 and a back passivation layer 8 on the other surface of the P-type silicon substrate 5 opposite to the front silicon oxide layer 3, and subsequently depositing a front silicon nitride layer 2 on the surface of the formed front silicon oxide layer 3. The specific steps are:
(1) a textured surface is formed on a silicon wafer surface by using a mixed solution of an alkali solution such as KOH and/or NaOH, water and an additive at 70-90°C, the additive is ethanol and/or isopropanol, and the alkali solution, the water and the additive have a volume ratio of (8-12):(240-360):(2-3);
   phosphorus diffusion is performed on the textured surface, an emitter 4 is formed on the surface of the P-type silicon substrate 5 by laser doping, a phosphorus-silicon layer on the residual surface of the P-type silicon substrate 5 is etched and removed by using an aqueous solution of HF, wherein the water and HF have a volume ratio of (35-45):3, and subsequently, a front silicon oxide layer 3 is formed on the surface of the emitter 4 by thermal oxidation;
(2) a silicon oxide passivation layer 6 is deposited on the other surface of the P-type silicon substrate 5 opposite to the front silicon oxide layer 3 by plasma-enhanced chemical vapor deposition with a deposition time of 30-150 s, SiH₄ or N₂O is used as a reaction gas in the deposition, SiH₄ has a volume flow rate of 550-700 sccm, and N₂O has a volume flow rate of 3000-3250 sccm; subsequently, a gallium oxide passivation layer 7 is deposited on the surface of the silicon oxide passivation layer 6 by any one of atomic layer deposition, plasma-enhanced chemical vapor deposition, atmospheric pressure chemical vapor deposition or low pressure chemical vapor deposition; a back passivation layer 8 is then deposited on the surface of the gallium oxide passivation layer 7 by plasma-enhanced chemical vapor deposition;
(3) a front silicon nitride layer 2 is deposited on the surface of the front silicon oxide layer 3 by plasma-enhanced chemical vapor deposition to complete the preparation of a front coating; and
(4) a gallium-doped back surface field is formed from the surface of the back passivation layer 8 to the inside of the P-type silicon substrate 5 by laser doping, and subsequently, a front electrode 1 and a back electrode 9 are formed by screen printing and sintering.

### Example 1

This example provides a gallium oxide back-passivated solar cell, which includes a P-type silicon substrate 5, and the P-type silicon substrate 5 is provided with a front coating and a back coating on the surfaces of opposite sides, respectively. A preparation method of the solar cell includes:
(1) a textured surface was formed on a silicon wafer surface by using a mixed solution of KOH, water and ethanol at 80°C, wherein KOH, water and ethanol had a volume ratio of 10:330:2.2; phosphorus diffusion was performed on the textured surface, an emitter 4 was formed on the surface of the P-type silicon substrate 5 by laser doping, a phosphorus-silicon layer on the residual surface of the P-type silicon substrate 5 was etched and removed by using an aqueous solution of HF, wherein water and HF had a volume ratio of 44:3, and subsequently, a front silicon oxide layer 3 with a thickness of 5 nm was formed on the surface of the emitter 4 by thermal oxidation;
(2) a silicon oxide passivation layer 6 with a thickness of 10 mm was deposited on the other surface of the P-type silicon substrate 5 opposite to the front silicon oxide layer 3 by plasma-enhanced chemical vapor deposition with a deposition time of 100 s, SiH₄ and N₂O were used as reaction gases in the deposition, SiH₄ had a volume flow rate of 700 sccm, and N₂O had a volume flow rate of 3250 sccm; subsequently, a gallium oxide passivation layer 7 with a thickness of 30 nm was deposited on the surface of the silicon oxide passivation layer 6 by atomic layer deposition; a silicon nitride passivation layer with a thickness of 80 nm was then deposited on the surface of the gallium oxide passivation layer 7 by plasma-enhanced chemical vapor deposition to complete the preparation of the back coating;
(3) a front silicon nitride layer 2 with a thickness of 80 nm was deposited on the surface of the front silicon oxide layer 3 by plasma-enhanced chemical vapor deposition to complete the preparation of the front coating; and
(4) a gallium-doped back surface field was formed from the surface of the silicon nitride passivation layer to the inside of the P-type silicon substrate 5 by laser doping, and subsequently, a front electrode 1 and a back electrode 9 were formed by screen printing and sintering;
wherein the front electrode 1 penetrated through the front silicon nitride layer 2, the front silicon oxide layer 3 and the emitter 4 in sequence and inserted into the P-type silicon substrate 5, and formed an Ohmic contact with the P-type silicon substrate 5; the back electrode 9 penetrated through the silicon nitride passivation layer, the gallium oxide passivation layer 7 and the silicon oxide passivation layer 6 in sequence and inserted into the P-type silicon substrate 5, and formed an Ohmic contact with the P-type silicon substrate 5.

### Example 2

This example provides a gallium oxide back-passivated solar cell, which includes a P-type silicon substrate 5, and the P-type silicon substrate 5 is provided with a front coating and a back coating on the surfaces of opposite sides, respectively. A preparation method of the solar cell includes:
(1) a textured surface was formed on a silicon wafer surface by using a mixed solution of NaOH, water and isopropanol at 70°C, wherein NaOH, water and isopropanol had a volume ratio of 10:240:2; phosphorus diffusion was performed on the textured surface, an emitter 4 was formed on the surface of the P-type silicon substrate 5 by laser doping, a phosphorus-silicon layer on the residual surface of the P-type silicon substrate 5 was etched and removed by using an aqueous solution of HF, wherein water and HF had a volume ratio of 35:3, and subsequently, a front silicon oxide layer 3 with a thickness of 1 nm was formed on the surface of the emitter 4 by thermal oxidation;
(2) a silicon oxide passivation layer 6 with a thickness of 1 mm was deposited on the other surface of the P-type silicon substrate 5 opposite to the front silicon oxide layer 3 by plasma-enhanced chemical vapor deposition with a deposition time of 30 s, SiH₄ and N₂O were used as reaction gases in the deposition, SiH₄ had a volume flow rate of 550 sccm, and N₂O had a volume flow rate of 3000 sccm; subsequently, a gallium oxide passivation layer 7 with a thickness of 10 nm was deposited on the surface of the silicon oxide passivation layer 6 by plasma-enhanced chemical vapor deposition; a silicon nitride passivation layer with a thickness of 10 nm was then deposited on the surface of the gallium oxide passivation layer 7 by plasma-enhanced chemical vapor deposition to complete the preparation of the back coating;
(3) a front silicon nitride layer 2 with a thickness of 10 nm was deposited on the surface of the front silicon oxide layer 3 by plasma-enhanced chemical vapor deposition to complete the preparation of the front coating; and
(4) a gallium-doped back surface field was formed from the surface of the silicon nitride passivation layer to the inside of the P-type silicon substrate 5 by laser doping, and subsequently, a front electrode 1 and a back electrode 9 were formed by screen printing and sintering;
wherein the front electrode 1 penetrated through the front silicon nitride layer 2, the front silicon oxide layer 3 and the emitter 4 in sequence and inserted into the P-type silicon substrate 5, and formed an Ohmic contact with the P-type silicon substrate 5; the back electrode 9 penetrated through the silicon nitride passivation layer, the gallium oxide passivation layer 7 and the silicon oxide passivation layer 6 in sequence and inserted into the P-type silicon substrate 5, and formed an Ohmic contact with the P-type silicon substrate 5.

### Example 3

This example provides a gallium oxide back-passivated solar cell, which includes a P-type silicon substrate 5, and the P-type silicon substrate 5 is provided with a front coating and a back coating on the surfaces of opposite sides, respectively. A preparation method of the solar cell includes:
(1) a textured surface was formed on a silicon wafer surface by using a mixed solution of KOH, water and ethanol at 75°C, wherein KOH, water and ethanol had a volume ratio of 8:300:3; phosphorus diffusion was performed on the textured surface, an emitter 4 was formed on the surface of the P-type silicon substrate 5 by laser doping, a phosphorus-silicon layer on the residual surface of the P-type silicon substrate 5 was etched and removed by using an aqueous solution of HF, wherein water and HF had a volume ratio of 37:3, and subsequently, a front silicon oxide layer 3 with a thickness of 2 nm was formed on the surface of the emitter 4 by thermal oxidation;
(2) a silicon oxide passivation layer 6 with a thickness of 5 mm was deposited on the other surface of the P-type silicon substrate 5 opposite to the front silicon oxide layer 3 by plasma-enhanced chemical vapor deposition with a deposition time of 70 s, SiH₄ and N₂O were used as reaction gases in the deposition, SiH₄ had a volume flow rate of 600 sccm, and N₂O had a volume flow rate of 3050 sccm; subsequently, a gallium oxide passivation layer 7 with a thickness of 20 nm was deposited on the surface of the silicon oxide passivation layer 6 by atmospheric pressure chemical vapor deposition; a silicon carbide passivation layer with a thickness of 60 nm was then deposited on the surface of the gallium oxide passivation layer 7 by plasma-enhanced chemical vapor deposition to complete the preparation of the back coating;
(3) a front silicon nitride layer 2 with a thickness of 60 nm was deposited on the surface of the front silicon oxide layer 3 by plasma-enhanced chemical vapor deposition to complete the preparation of the front coating; and
(4) a gallium-doped back surface field was formed from the surface of the silicon carbide passivation layer to the inside of the P-type silicon substrate 5 by laser doping, and subsequently, a front electrode 1 and a back electrode 9 were formed by screen printing and sintering;
wherein the front electrode 1 penetrated through the front silicon nitride layer 2, the front silicon oxide layer 3 and the emitter 4 in sequence and inserted into the P-type silicon substrate 5, and formed an Ohmic contact with the P-type silicon substrate 5; the back electrode 9 penetrated through the silicon carbide passivation layer, the gallium oxide passivation layer 7 and the silicon oxide passivation layer 6 in sequence and inserted into the P-type silicon substrate 5, and formed an Ohmic contact with the P-type silicon substrate 5.

### Example 4

This example provides a gallium oxide back-passivated solar cell, which includes a P-type silicon substrate 5, and the P-type silicon substrate 5 is provided with a front coating and a back coating on the surfaces of opposite sides, respectively. A preparation method of the solar cell includes:
(1) a textured surface was formed on a silicon wafer surface by using a mixed solution of NaOH, water and isopropanol at 80°C, wherein NaOH, water and isopropanol had a volume ratio of 10:360:3; phosphorus diffusion was performed on the textured surface, an emitter 4 was formed on the surface of the P-type silicon substrate 5 by laser doping, a phosphorus-silicon layer on the residual surface of the P-type silicon substrate 5 was etched and removed by using an aqueous solution of HF, wherein water and HF had a volume ratio of 40:3, and subsequently, a front silicon oxide layer 3 with a thickness of 3 nm was formed on the surface of the emitter 4 by thermal oxidation;
(2) a silicon oxide passivation layer 6 with a thickness of 8 mm was deposited on the other surface of the P-type silicon substrate 5 opposite to the front silicon oxide layer 3 by plasma-enhanced chemical vapor deposition with a deposition time of 80 s, SiH₄ and N₂O were used as reaction gases in the deposition, SiH₄ had a volume flow rate of 650 sccm, and N₂O had a volume flow rate of 3200 sccm; subsequently, a gallium oxide passivation layer 7 with a thickness of 40 nm was deposited on the surface of the silicon oxide passivation layer 6 by low pressure chemical vapor deposition; a silicon oxynitride passivation layer with a thickness of 70 nm was then deposited on the surface of the gallium oxide passivation layer 7 by plasma-enhanced chemical vapor deposition to complete the preparation of the back coating;
(3) a front silicon nitride layer 2 with a thickness of 70 nm was deposited on the surface of the front silicon oxide layer 3 by plasma-enhanced chemical vapor deposition to complete the preparation of the front coating; and
(4) a gallium-doped back surface field was formed from the surface of the silicon oxynitride passivation layer to the inside of the P-type silicon substrate 5 by laser doping, and subsequently, a front electrode 1 and a back electrode 9 were formed by screen printing and sintering;
wherein the front electrode 1 penetrated through the front silicon nitride layer 2, the front silicon oxide layer 3 and the emitter 4 in sequence and inserted into the P-type silicon substrate 5, and formed an Ohmic contact with the P-type silicon substrate 5; the back electrode 9 penetrated through the silicon oxynitride passivation layer, the gallium oxide passivation layer 7 and the silicon oxide passivation layer 6 in sequence and inserted into the P-type silicon substrate 5, and formed an Ohmic contact with the P-type silicon substrate 5.

### Example 5

This example provides a gallium oxide back-passivated solar cell, which includes a P-type silicon substrate 5, and the P-type silicon substrate 5 is provided with a front coating and a back coating on the surfaces of opposite sides, respectively. A preparation method of the solar cell includes:
(1) a textured surface was formed on a silicon wafer surface by using a mixed solution of a mixed NaOH and KOH solution, water and isopropanol at 80°C, wherein the mixed NaOH and KOH solution, water and isopropanol had a volume ratio of 12:360:3; phosphorus diffusion was performed on the textured surface, an emitter 4 was formed on the surface of the P-type silicon substrate 5 by laser doping, a phosphorus-silicon layer on the residual surface of the P-type silicon substrate 5 was etched and removed by using an aqueous solution of HF, wherein water and HF had a volume ratio of 42:3, and subsequently, a front silicon oxide layer 3 with a thickness of 4 nm was formed on the surface of the emitter 4 by thermal oxidation;
(2) a silicon oxide passivation layer 6 with a thickness of 12 mm was deposited on the other surface of the P-type silicon substrate 5 opposite to the front silicon oxide layer 3 by plasma-enhanced chemical vapor deposition with a deposition time of 120 s, SiH₄ and N₂O were used as reaction gases in the deposition, SiH₄ had a volume flow rate of 680 sccm, and N₂O had a volume flow rate of 3200 sccm; subsequently, a gallium oxide passivation layer 7 with a thickness of 80 nm was deposited on the surface of the silicon oxide passivation layer 6 by plasma-enhanced chemical vapor deposition; a back passivation layer 8 with a thickness of 150 nm was then deposited on the surface of the gallium oxide passivation layer 7 by plasma-enhanced chemical vapor deposition, and the back passivation layer 8 was a silicon nitride passivation layer;
(3) a front silicon nitride layer 2 with a thickness of 150 nm was deposited on the surface of the front silicon oxide layer 3 by plasma-enhanced chemical vapor deposition to complete the preparation of the front coating; and
(4) a gallium-doped back surface field was formed from the surface of the back passivation layer 8 to the inside of the P-type silicon substrate 5 by laser doping, and subsequently, a front electrode 1 and a back electrode 9 were formed by screen printing and sintering;
wherein the front electrode 1 penetrated through the front silicon nitride layer 2, the front silicon oxide layer 3 and the emitter 4 in sequence and inserted into the P-type silicon substrate 5, and formed an Ohmic contact with the P-type silicon substrate 5; the back electrode 9 penetrated through the back passivation layer 8, the gallium oxide passivation layer 7 and the silicon oxide passivation layer 6 in sequence and inserted into the P-type silicon substrate 5, and formed an Ohmic contact with the P-type silicon substrate 5.

### Example 6

This example provides a gallium oxide back-passivated solar cell, which includes a P-type silicon substrate 5, and the P-type silicon substrate 5 is provided with a front coating and a back coating on the surfaces of opposite sides, respectively. A preparation method of the solar cell includes:
(1) a textured surface was formed on a silicon wafer surface by using a mixed solution of NaOH, water and isopropanol at 90°C, wherein NaOH, water and isopropanol had a volume ratio of 12:330: 2.2; phosphorus diffusion was performed on the textured surface, an emitter 4 was formed on the surface of the P-type silicon substrate 5 by laser doping, a phosphorus-silicon layer on the residual surface of the P-type silicon substrate 5 was etched and removed by using an aqueous solution of HF, wherein water and HF had a volume ratio of 45:3, and subsequently, a front silicon oxide layer 3 with a thickness of 5 nm was formed on the surface of the emitter 4 by thermal oxidation;
(2) a silicon oxide passivation layer 6 with a thickness of 15 mm was deposited on the other surface of the P-type silicon substrate 5 opposite to the front silicon oxide layer 3 by plasma-enhanced chemical vapor deposition with a deposition time of 150 s, SiH₄ and N₂O were used as reaction gases in the deposition, SiH₄ had a volume flow rate of 680 sccm, and N₂O had a volume flow rate of 3200 sccm; subsequently, a gallium oxide passivation layer 7 with a thickness of 100 nm was deposited on the surface of the silicon oxide passivation layer 6 by low pressure chemical vapor deposition; a silicon carbide passivation layer with a thickness of 200 nm was then deposited on the surface of the gallium oxide passivation layer 7 by plasma-enhanced chemical vapor deposition to complete the preparation of the back coating;
(3) a front silicon nitride layer 2 with a thickness of 200 nm was deposited on the surface of the front silicon oxide layer 3 by plasma-enhanced chemical vapor deposition to complete the preparation of the front coating; and
(4) a gallium-doped back surface field was formed from the surface of the silicon carbide passivation layer to the inside of the P-type silicon substrate 5 by laser doping, and subsequently, a front electrode 1 and a back electrode 9 were formed by screen printing and sintering;
wherein the front electrode 1 penetrated through the front silicon nitride layer 2, the front silicon oxide layer 3 and the emitter 4 in sequence and inserted into the P-type silicon substrate 5, and formed an Ohmic contact with the P-type silicon substrate 5; the back electrode 9 penetrated through the silicon carbide passivation layer, the gallium oxide passivation layer 7 and the silicon oxide passivation layer 6 in sequence and inserted into the P-type silicon substrate 5, and formed an Ohmic contact with the P-type silicon substrate 5.

### Comparative Example 1

This comparative example provides a solar cell, which differs from Example 1 in that no silicon oxide passivation layer 6 is arranged between the P-type silicon substrate 5 and the gallium oxide passivation layer 7, and the other features are exactly the same as those of Example 1.

### Comparative Example 2

This comparative example provides a solar cell, which differs from Example 1 in that the gallium oxide passivation layer 7 is replaced with an aluminum oxide passivation layer, and the other features are exactly the same as those of Example 1.

The open-circuit voltage (Uoc), short-circuit current (Isc), fill factor (FF) and photoelectric conversion efficiency (Eta) of the solar functional cells provided by Examples 1-6, Comparative Example 1 and Comparative Example 2 are measured individually and the results are shown in Table 1.

**Table 1**

| No. | Uoc (V) | Isc (A) | FF (%) | Eta (%) |
|---|---|---|---|---|
| Example 1 | 0.697 | 11.198 | 81.14 | 23.10 |
| Example 2 | 0.694 | 11.188 | 81.14 | 22.98 |
| Example 3 | 0.694 | 11.190 | 81.19 | 23.00 |
| Example 4 | 0.695 | 11.192 | 81.24 | 23.05 |
| Example 5 | 0.696 | 11.195 | 81.13 | 23.06 |
| Example 6 | 0.696 | 11.198 | 81.18 | 23.08 |
| Comparative Example 1 | 0.692 | 11.189 | 81.29 | 22.96 |
| Comparative Example 2 | 0.690 | 11.191 | 81.30 | 22.90 |

It can be seen from Table 1 that the photoelectric conversion efficiency (Eta) of solar cells in Examples 1-6 is higher than that in Comparative Example 1, which is mainly resulted from the fact that the silicon oxide passivation layer 6 arranged between the P-type silicon substrate 5 and the gallium oxide passivation layer 7 can effectively reduce the surface state density and further enhance the chemical passivation effect. The open-circuit voltage (Uoc) of solar cells in Examples 1-6 is higher than that in Comparative Example 2, which is resulted from the fact that compared with aluminum oxide, gallium oxide has a wider forbidden bandwidth and can achieve a higher open-circuit voltage.

For the gallium oxide back-passivated solar cell and the preparation method therefor provided by the present application, the field-effect passivation resulted from gallium oxide by fixing negative charges is used in conjunction with the chemical passivation of silicon oxide to further reduce carrier recombination; the silicon oxide passivation layer 6 with controllable thickness, which is deposited between the gallium oxide passivation layer 7 and the P-type silicon substrate 5, can effectively reduce the surface state density and further enhance the chemical passivation effect.

The applicant declares that the above is embodiments of the present application, but the protection scope of the present application is not limited thereto.

## Claims

1. A gallium oxide back-passivated solar cell, wherein the solar cell comprises a P-type silicon substrate, the P-type silicon substrate is provided with a front coating and a back coating on the surfaces of opposite sides, respectively; the front coating comprises an emitter, a front silicon oxide layer and a front silicon nitride layer stacked in sequence outward from the surface of the P-type silicon substrate, and the back coating comprises a silicon oxide passivation layer, a gallium oxide passivation layer and a back passivation layer stacked in sequence outward from the surface of the P-type silicon substrate.

2. The solar cell according to claim 1, wherein the cell comprises a front electrode which penetrates through the front silicon nitride layer, the front silicon oxide layer and the emitter in sequence and inserts into the P-type silicon substrate, and the front electrode forms an Ohmic contact with the P-type silicon substrate.

3. The solar cell according to claim 2, wherein the cell further comprises a back electrode which penetrates through the back passivation layer, the gallium oxide passivation layer and the silicon oxide passivation layer in sequence and inserts into the P-type silicon substrate, and the back electrode forms an Ohmic contact with the P-type silicon substrate.

4. The solar cell according to any one of claims 1 to 3, wherein the back passivation layer comprises any one or a combination of at least two of silicon nitride, silicon oxynitride or silicon carbide.

5. The solar cell according to any one of claims 1 to 4, wherein the silicon oxide passivation layer has a thickness of 1-15 nm;
optionally, the gallium oxide passivation layer has a thickness of 10-100 nm, further optionally 20-40 nm;
optionally, the back passivation layer has a thickness of 10-200 nm, further optionally 60-80 nm;
optionally, the front silicon oxide layer has a thickness of 1-5 nm;
optionally, the front silicon nitride layer has a thickness of 10-200 nm, further optionally 60-80 nm.

6. A preparation method for the solar cell according to any one of claims 1 to 5, comprising:
performing laser doping to form an emitter on one surface of a P-type silicon substrate, then performing thermal oxidation to form a front silicon oxide layer, subsequently depositing a silicon oxide passivation layer, a gallium oxide passivation layer and a back passivation layer in sequence on the other surface of the P-type silicon substrate opposite to the front silicon oxide layer, and subsequently depositing a front silicon nitride layer on the surface of the formed front silicon oxide layer.

7. The preparation method according to claim 6, which specifically comprises:
(I) performing texturization on a silicon wafer surface to form a textured surface, then performing phosphorus diffusion on the surface, then performing laser doping to form an emitter on the surface of a P-type silicon substrate, etching and removing a phosphorus-silicon layer on the residual surface of the P-type silicon substrate, and subsequently performing thermal oxidation on the surface of the emitter to form a front silicon oxide layer;
(II) depositing a silicon oxide passivation layer, a gallium oxide passivation layer and a back passivation layer in sequence on the other surface of the P-type silicon substrate opposite to the front silicon oxide layer to obtain a back coating;
(III) depositing a front silicon nitride layer on the surface of the formed front silicon oxide layer to complete the preparation of a front coating; and
(IV) performing laser doping to form a gallium-doped back surface field from the surface of the back passivation layer to the inside of the P-type silicon substrate, and subsequently performing screen printing and sintering to form a front electrode and a back electrode.

8. The preparation method according to claim 7, wherein in step (I), a mixed solution of an alkali solution, water and an additive is used to form the textured surface on the silicon wafer surface;
optionally, the alkali solution, the water and the additive have a volume ratio of (8-12): (240-360):(2-3);
optionally, the texturization has a temperature of 70-90°C;
optionally, the alkaline solution is KOH and/or NaOH;
optionally, the additive is ethanol and/or isopropanol.

9. The preparation method according to claim 7 or 8, wherein in step (I), the phosphorus-silicon layer is removed from the surface of the P-type silicon substrate with an acid solution by wet etching;
optionally, the acid solution is an aqueous solution of HF;
optionally, the water and HF in the acid solution have a volume ratio of (35-45):3.

10. The preparation method according to any one of claims 7 to 9, wherein in step (II), plasma-enhanced chemical vapor deposition is used to deposit the silicon oxide passivation layer on the surface of the P-type silicon substrate;
optionally, the silicon oxide passivation layer has a deposition time of 30-150 s;
optionally, SiH₄ and N₂O are used as reaction gases in the deposition of the silicon oxide passivation layer;
optionally, the SiH₄ has a volume flow rate of 550-700 sccm;
optionally, the N₂O has a volume flow rate of 3000-3250 sccm;
optionally, plasma-enhanced chemical vapor deposition is used to deposit the back passivation layer;
optionally, a preparation method for the gallium oxide passivation layer comprises atomic layer deposition, plasma-enhanced chemical vapor deposition, atmospheric pressure chemical vapor deposition or low pressure chemical vapor deposition.

11. The preparation method according to any one of claims 7 to 10, wherein in step (III), plasma-enhanced chemical vapor deposition is used to deposit the front silicon nitride layer on the surface of the front silicon oxide layer.
